Europäisches Patentamt

European Patent Office

Office européen des brevets

(19)

(11) Publication number: **0 163 461 B1**

## EUROPEAN PATENT SPECIFICATION

(45) Date of publication of patent specification: 02.05.91    (51) Int. Cl.5: **H03F 3/26**

(21) Application number: **85303482.5**

(22) Date of filing: **17.05.85**

(54) **Non biased push-pull amplifiers.**

(30) Priority: **30.05.84 US 615217**
           **29.05.84 US 614631**

(43) Date of publication of application:
**04.12.85 Bulletin 85/49**

(45) Publication of the grant of the patent:
**02.05.91 Bulletin 91/18**

(84) Designated Contracting States:
**DE FR GB IT**

(56) References cited:
**DE-A- 2 453 597**
**DE-A- 3 232 610**
**DE-B- 1 166 833**
**US-A- 3 683 289**
**US-A- 4 374 363**

**U. TIETZE et al.:**
**"Halbleiter-Schaltungstechnik", 4th edition,**
**page 339, 1978, Springer-Verlag;**

**JOURNAL OF PHYSICS E-SCIENTIFIC IN-**
**STRUMENTS, vol. 13, no. 9, September 1980,**
**pages 947-955, London, GB; HUTCHISON et**
**al.: "A whole-body NMR imaging machine"**

(73) Proprietor: **Donovan, John S.**
**16503 Santa Rosa**
**Detroit Michigan 48221(US)**

(72) Inventor: **Donovan, John S.**
**16503 Santa Rosa**
**Detroit Michigan 48221(US)**

(74) Representative: **Williams, Trevor John et al**
**J.A. KEMP & CO. 14 South Square Gray's Inn**
**London WC1R 5EU(GB)**

## Description

When using Metal Oxide Semiconductor/Field Effect Transistors (MOS-FETs), it is general knowledge that as amplifiers they are limited to small signal situations. It is also known that when they are structured as depletion type devices that their ability to amplify incoming signals is ot restricted to the reversed biased range of their gate to source voltage handling limitations; but will tolerate temporary excursions into the forward biased range without degrading the impedance between the gate and the source. I have found that this characteristic makes possible a zero biased arrangement for the purpose of signal amplification with it also being possible to structure MOS-FETs in a push-pull arrangement so that the abovementioned potential can be maximised.

The fact that the transconductance of such transistors increases in proportion to the on-resistance makes it desirable to structure the channel's cross-sectional dimensions as small as possible. The recent use of lasers in the manufacturing of said devices can reduce such dimensions to much less than one micron, with a high degree of consistency in maintaining such dimensions.

After considering the above mentioned abilities when used in combination, it is realistic to expect a gigantic increase in performance. Said increase would not necessarily manifest itself by virtue of a larger output signal; but more so by the ability of the incoming signal to overcome the internal noise that is inherent in all small signal amplifiers.

A typical amplifier using a push-pull arrangement of MOS-FETs in accordance with the prior art portion of claim 1 is disclosed in "Journal of Physics E-Scientific Instruments, Vol 13, No 9, September 1980, page 950". This prior proposal utilised biasing resistors and thus does not appreciate the advantages which can be achieved by omitting the biasing resistors as required by the present invention.

It is an object of the present invention to provide an extremely sensitive amplifier arrangement which can be employed in a wide range of applications and which is not limited in performance by the need for biasing resistors.

The present invention provides an extremely sensitive amplifier arrangement which is not subject to clipping the incoming signal at the output of the amplifier even though the gates of the transistors may be driven beyond the pinch-off voltage; thus increasing the minimum to maximum signal handling ability.

With the arrangement as later described the extremely sensitive amplifier arrangement has the inherent logarithmic characteristics of the transistors of the first amplifying stage greatly reduced with the variations of the amplification ratio of said stage being reduced by a succeeding amplifying stage.

The amplifier arrangement can have the generally associated accessories included so as to extend their effective range insofar as said accessories can be applied to a radio wave amplifier.

As will be explained, amplifiers embodying the invention use the opposed positioning of two MOS-FETs (depletion type). These devices, which are connected directly together at their source ends and connected indirectly together at their drain ends through a centre-tapped electromagnetic induction coil or load resistor, represent the essential components of the arrangement. Said electromagnetic induction coil functions as the primary side of a transformer coupling whereas said load resistor requires a capacitor at both ends in order to do the same.

The input to the gates of the opposing transistors can come from the secondary side of a transformer which indirectly ties the two gates together or from the two ends of a microphone diaphragm coil, which also indirectly ties the two gates together. Said input could also come through two separate capacitors. A tuning capacitor is disposed between the gates of the transistors when the secondary side of the transformer is employed for the purpose of accommodating radio frequencies. The need for centre-tapping the secondary side of the transformer that conducts incoming signals to the gates has been eliminated.

The circuit is intended to function as an amplifier, but without the need for biasing resistors. With a zero bias the voltage handling ability between the source end of the transistors and their respective input gates is of equal potential into either the forward or reverse voltage range before the impedance between the gate and the channel is destroyed. As the channel's cross-sectional dimensions are intended to be extremely small, the reverse polarity swing of the gate to source would cause the channel's electrical conductivity to cease long before the abovementioned limitation is reached. In order to exploit the full potential of the gate to source voltage handling ability a push-pull configuration is required. The forward polarity swing of the gate to source would be to a point of higher transconductance which would greatly reduce the clipping effect of the alternate transistor's shift to pinch-off voltage which would be to a point of less transconductance. The extremely small cross-sectional dimensions of the channel are integral with the desire for overall higher transconductance characteristics.

The supply voltage available to the symmetrical portion of the embodiment may be limited by inserting a variable resistor into the line leading to the point of juncture between the source ends of the two transistors. Said resistance could be either of a manual or transistorized control.

A second optional control may be included by positioning a MOS-FET (enhanced type) between and connected to the two wires leading to the primary side of the transformer preceding the first amplifying stage when said essential components are used for amplifying radio frequencies. The inclusion of such a component will allow the employment of MOS-FETs (depletion type) as amplifiers with an unusually thin layer of silicon dioxide which acts as an insulator between the gate and the channel. This increases the ability of the incoming signal to overcome the inherent noise without fear of burning out the insulating layer due to the extreme strength variation of the incoming signals. Said extreme variation is particularly associated with radar applications.

In order to maximize the effectiveness of the device the surface area between the two extremes of the voltage induced channel can be enlarged by diffusing said extremes so as to be dispositioned into relatively long parallel lines in close proximity thus reducing the channel's on-resistance. An inclusion of this type of transistor involves a unique arrangement in that the source end and the drain end of said component are not established as in all other circuitry; but are continually exchanging polarity at the same rate as the incoming signal. In order for such a relationship to effectively operate neither end of the voltage induced channel of the enhanced type transistor can be grounded. Said channel is induced by generating a sufficient voltage of the proper polarity between the gate and the substrate in order to partially and controllably short circuit the primary side of the transformer coupling preceding the first amplifying stage. The inclusion of two biasing resistors is for the purpose of bringing such a type of transistor to its required threshold voltage.

A third optional function applicable to both analogue and sinusoidal configurations is the matching of depletion type transistors to enhanced type MOS-FETs or enchanced type MOS-Power Transistors. The purpose of directly coupling the two different type of transistors is that as the depletion type are shifted to a point of lesser transconductance the enhanced type would be shifted to a point of greater transconductance. This relationship tends to stabilize the amplification ratio regardless of the variations in the signal strength at the input of the circuit. The possible application of either of the two different type of enhanced transistors would be dependent on the intent for which the circuit was meant. Enhanced MOS-FETs are strictly for small signals such as radio or radar receivers; while MOS-Power Transistors are for high power applications such as a transmitter or line driver situation. Those configurations in which the possibility of the first amplifying stage's transistors being driven beyond pinch-off voltage would require the succeeding stage's transistors to have a voltage applied to their gates that would be well above threshold.

Description of the Drawings

FIGURE 1 is a schematic representation of the amplifier arrangement when configured for a radio wave receiver;
FIGURE 2A is a schematic representation of the amplifier arrangement when configured for a preamplifier for an audio or ultrasonic microphone;
FIGURE 2B is a schematic representation of a variation of the configuration shown in FIGURE 2A.
FIGURE 3A is a schematic representation of the amplifier arrangement when configured for the first stage of an analogue system such as would be found after the demodulator in a radio or radar receiver.
FIGURE 3B is a schematic representation of a variation of the configuration shown in FIGURE 3A.
FIGURE 4A is a schematic representation of the amplifier arrangement intended as an extension of the configurations represented by FIGURES 1, 2A, 2B, 3A and 3B.
FIGURE 4B is a schematic representation of the amplifier arrangement intended as a variation of the extension of the configuration represented by FIGURE 4A.

Detailed Description

In the following detailed description, certain specific terminology will be utilized for the sake of clarity and a particular embodiment described in accordance with the disclosure requirements, but is to be understood that the same is not intended to be limiting and should not be construed inasmuch as the invention is capable of taking many forms and variations within the scope of the appended claims.

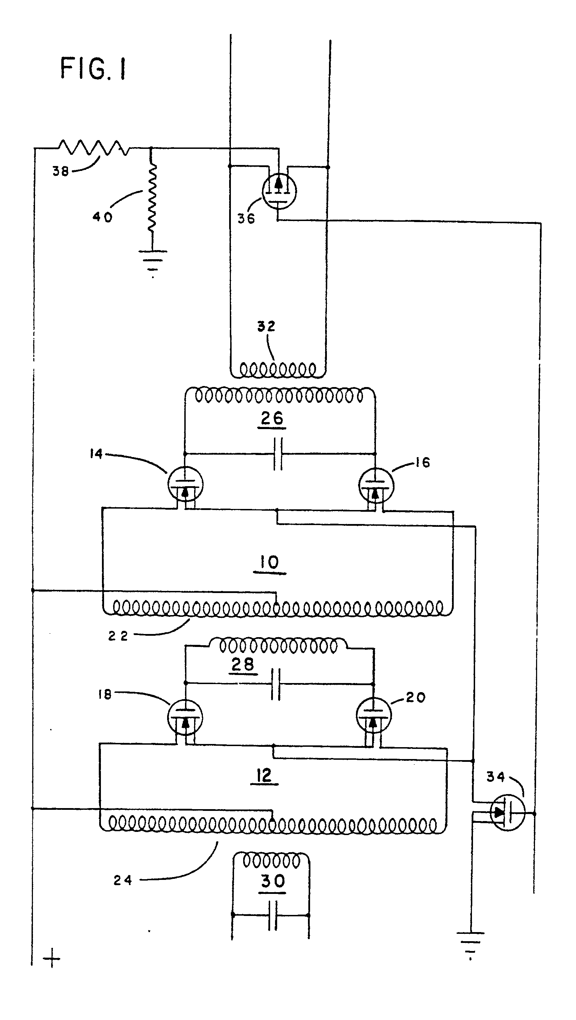

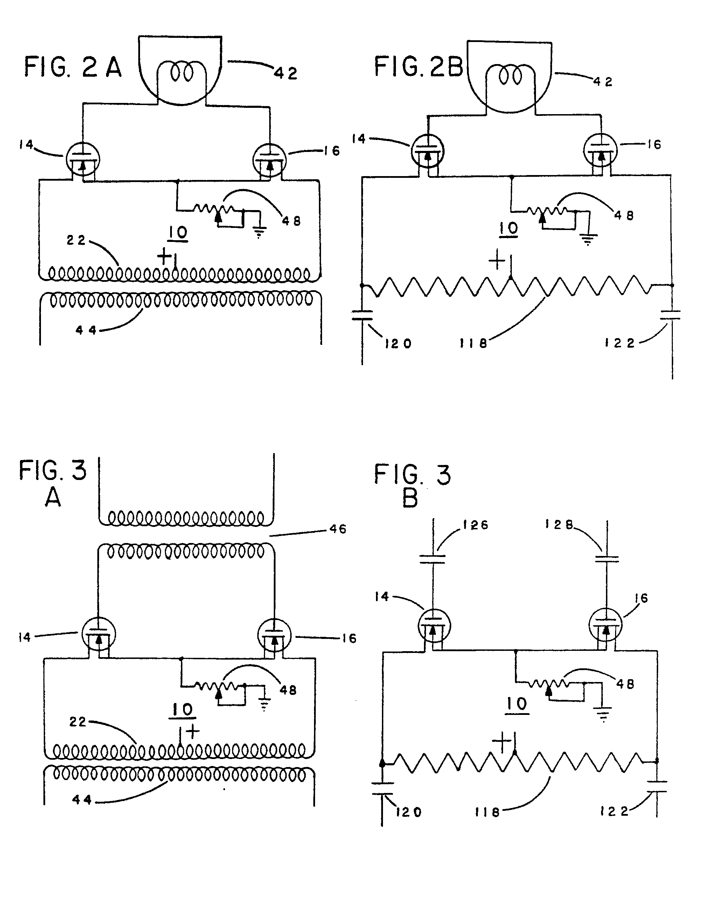

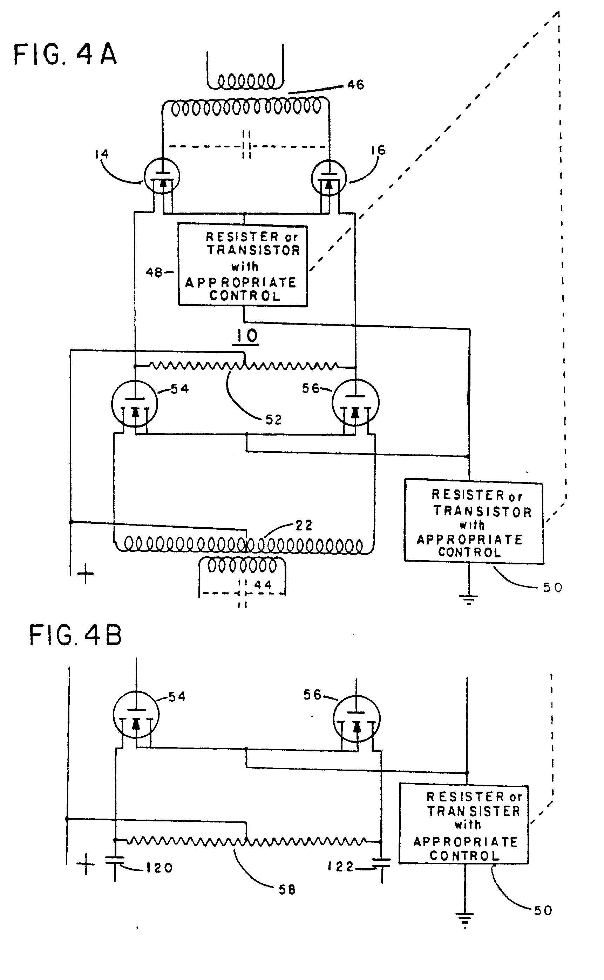

Referring to FIGURE 1, the essential components of all the configurations shown are indicated generally by the numbers 10 and 12. This encompasses transistors 14 and 16 of the first amplifying stage, transistors 18 and 20 of the second amplifying stage and electromagnetic induction coils 22 and 24 of the above mentioned amplifying stages accordingly. With capacitor coupled variations said induction coils are replaced by a load resistor 118 (Fig. 2B) or 52 (Fig. 4A).

As this configuration is for the purpose of dealing with radio waves the essential components for such are indicated by the numbers 26, 28 and 30 which represent radio wave tuned circuits that receive their energy from the induction coils 32, 22 and 24. The first electromagnetic induction coil 32 and the center-tapped electromagnetic induction coils 22 and 24 serve as the primaries of the amplifying stages transformer couplings. The coils of the radio wave tuned circuits function as the secondaries of said couplings.

Transistor 34 limits the magnitude of the signal at the output of the circuit by inhibiting the amount of supply voltage to the amplifying stages. This will reduce the supply voltage to pinch-off voltage ratio. The control of such would determine the amplification ratio of both amplifying stage simultaneously. An extension of the aforementioned ability can be brought by the inclusion of a second transistor 36 of which the characteristics are unlike the other transistors in the circuit. This device best known as an enhanced type MOS-FET is wired in parallel with the first electromagnetic induction coil 32 such that neither the source end or the drain end is identifiable because neither lead wire to the first electromagnetic induction coil 32 is grounded. If sufficient voltage of the proper polarity is generated between the gate and the substrate of transistor 36 a partial short circuiting of the electromagnetic induction coil 32 will occur and then become overwhelming as the difference in voltage between the gate and the substrate increases. Transistors 34 and 36 receive their gate controlling voltage through a common lead line. Threshold voltage for transistor 36 is partly achieved by the inclusion of biasing resistors 38 and 40.

Referring to FIGURE 2A, the same set of numbers are used to indicate the essential components of the first amplifying stage of FIGURE 1 are also used. As this configuration is for the purpose of audio or ultrasonic sound the radio wave circuitry of FIGURE 1 is now replaced by a microphone 42 and is included similarly in that the two ends of the microphone diaphragm coil are connected directly to the gates of the transistors 14 and 16.

The secondary side of the transformer indicated by the number 44 couples the preamplifier through the primary side of the transformer indicated by the number 22 to any succeeding amplifying stage. A manual gain control 48 can be included in much the same manner as the automatic gain control of FIGURE 1.

Referring to FIGURE 3A, the same set of numbers used to indicate the essential components of the first amplifying stage of FIGURE 1 are also used. Though similar in configuration to FIGURE 1 the intended frequency handling abilities of the FIGURE 3A arrangement would be much more like the frequencies utilized by the arrangement shown in FIGURE 2A. The only significant difference between FIGURES 2A and 3A is the inputting of the incoming signal to transistors 14 and 16 through transformer 46. A manual gain control 48 can be included in much the same manner as that of FIGURE 2A. The output of this configuration is exactly the same as the previously explained configuration in the preceding paragraph.

Referring to FIGURE 2B, this configuration is much like that shown in FIGURE 2A. This encompasses transistors 14 and 16; but utilizes load resistor 118 and coupling capacitors 120 and 122 in place of a transformerized coupling to any succeeding circuit. Resister 48 functions the same as the manual gain control of FIGURE 2A.

Referring to FIGURE 3B, this configuration is much like that shown in FIGURE 3A. This encompasses transistors 14 and 16; but utilizes load resistor 118 and coupling capacitors 120 and 122 in place of a transformerized coupling to any succeeding circuit. The input to the transistors consists of separate capacitors 126 and 128. Resistor 48 functions the same as the manual gain control of FIGURE 3A.

Referring to FIGURE 4A, the same set of numbers used to indicate the essential components of the first amplifying stage of FIGURE 1 are again used; except a load resistor 52 now replaces the electromagnetic coil 22 as the output of the transistors 14 and 16 are connected directly to the inputs of the enhanced type transistors 54 and 56. A center-tapped load resistor 52 functions as a means to the positive side of the supply voltage for the first amplifying stage. The voltage drop across the depletion type transistors of the first amplifying stage also function as a threshold generator for the succeeding amplifying stage's enhanced type transistors. A calibrating resistor 48 is included to assist in acquiring the desired threshold voltage. Volume control 50 is connected to both amplifying stages. The first stage connection can be through said calibrating resistor 48 to the common reference electrode of the first amplifying stage's transistors, while the second stage connection is directly to the common reference electrode of the second amplifying stage's transistors. A mechanical linkage between calibrating resistor 48 and volume control resistor 50 can be included in such a manner so that the resistance of both devices are increased simultaneously in order to stabilize the voltage drop between the negative end of calibrating resistor 48 and the input electrodes of the two enhanced type transistors 54 and 56. Resistors 48 and 50 can be replaced by transistors that are controlled by a common applied voltage line in much the same manner as the mechanical linkage of said resistors. The input to this configuration could be any one of the previously disclosed type;

but the output of said configuration is intended to be the same as that of FIGURE 1, 2A, and 3A.

Referring to FIGURE 4B, the only significant difference between said figure and FIGURE 4A is the outputting of the amplified signal through two separate coupling capacitors 120 and 122 which are indirectly connected by a center-tapped load resistor 58 as a means to the positive side of the supply voltage for the second amplifying stage.

## Claims

1. An amplifier comprising a first and second depletion type MOS-FET transistor (14,16), each having a separate input electrode, a separate output electrode and a directly combined reference electrode, input means (32,42,46) connecting the input electrodes of said first and second transistors for deriving first input signals for said first transistor and second input signals of opposite phase for said second transistor from said input means to said transistors, output means (22) connected between the output electrodes of said first and second transistors for combining first amplified signals provided by said first transistor and second amplified signals provided by said second transistor to provide output signals for a push-pull stage, characterised in that free swinging of the polarity between the reference electrode and input electrode of the respective transistors is permitted by the absence of biasing resistor means.

2. An amplifier according to claim 1, wherein controllable resistance means (34,448) are connected to said directly combined reference electrodes to limit supply voltage to the amplifying stage.

3. An amplifier according to claim 2, wherein said resistance means includes a manual control (48).

4. An amplifier according to claim 2, wherein said resistance means includes a transistorised control (34).

5. An amplifier according to claim 2, 3 or 4, wherein said resistance means (34) is connected to the directly combined reference electrodes of more than one successive pair of amplifying MOS-FET transistors (14,16;18,20).

6. An amplifier according to any preceding claim, wherein said input means comprises a transformer coupling's secondary winding indirectly connecting said separate input electrodes of said first and second transistors.

7. An amplifier according to claim 6, wherein capacitor means is connected between the input electrodes of said first and second transistor for deriving in combination with said input means (32).

8. An amplifier according to any one of claims 1 to 5, wherein said input means comprises two separate capacitors (126,128), each connected to a separate one of said separate input electrodes of said first and second transistors.

9. An amplifier according to any one of claims 1 to 5, wherein said input means comprises a microphone (42) directly connected to said separate input electrodes of said first and second transistors.

10. An amplifier according to claim 6, wherein an enhanced type MOS-FET transistor (36) is provided between the leads to the primary winding (32) of said transformer coupling.

11. An amplifier according to any preceding claim, wherein an amplifier stage succeeding said first and second MOS-FET transistors comprises MOS-Power transistors.

12. An amplifier according to any preceding claim, wherein depletion type transistors are matched with and directly connected to said enhanced type MOS-FET transistors.

## Revendications

1. Un amplificateur comprenant un premier et un second transistor à déplétion de type MOS-FET (14, 16), chaque transistor étant doté d'une électrode d'entrée indépendante, d'une électrode de sortie indépendante et d'une électrode de référence indépendante directement combinée, un dispositif d'entrée (32,42,46) reliant les électrodes d'entrée desdits premier et second transistors afin de dériver les signaux de la première entrée vers le premier transistor et les signaux de la seconde entrée de phase opposée vers le second transistor, dudit dispositif d'entrée vers lesdits transistors, un dispositif de sortie (22) raccordé entre les électrodes de sortie desdits premier et second transistors afin de combiner les premiers signaux amplifiés délivrés par le premier transistor et les seconds signaux amplifiés délivrés par le second transistor dans le but de fournir des signaux de sortie destinés à un étage push-pull, caractérisé en ce qu'une inversion libre de la polarité entre l'électrode de référence et l'électrode d'entrée des transistors respectifs est rendue possible par l'absence de résistance de polarisation.

2. Amplificateur selon la revendication 1, caractérisé en ce qu'un dispositif de résistance réglable (34,448) est relié auxdites électrodes de référence directement combinées afin de limiter la tension d'alimentation de l'étage amplificateur.

3. Amplificateur selon la revendication 2, caractérisé en ce que ledit dispositif de résistance est doté d'une commande manuelle (48).

4. Amplificateur selon la revendication 2, caractérisé en ce que ledit dispositif de résistance est doté d'une commande à transistors (34).

5. Amplificateur selon la revendication 2, 3 ou 4, caractérisé en ce que ledit dispositif de résistance (34) est relié aux électrodes de référence directement combinées de plus d'une paire successive de transistors d'amplification MOS-FET (14,16;18,20).

6. Amplificateur selon l'une des revendications précédentes, caractérisé en ce que ledit dispositif d'entrée comprend un enroulement secondaire de couplage de transformateur, reliant indirectement lesdites électrodes d'entrée indépendantes desdits premier et second transistors.

7. Amplificateur selon la revendication 6, caractérisé en ce que le dispositif de condensateur est raccordé entre les électrodes d'entrée desdits premier et second transistors afin de dériver en combinaison avec ledit dispositif d'entrée (32).

8. Amplificateur selon l'une des revendications 1 à 5, caractérisé en ce que ledit dispositif d'entrée comprend deux condensateurs séparés (126,128), chacun étant raccordé respectivement à une électrode d'entrée indépendante desdits premier et second transistors.

9. Amplificateur selon l'une des revendications 1 à 5, caractérisé en ce que ledit dispositif d'entrée comprend un microphone (42) directement connecté auxdites électrodes d'entrée indépendantes desdits premier et second transistors.

10. Amplificateur selon la revendication 6, caractérisé en ce qu'un transistor de type MOS-FET à enrichissement (36) est prévu entre les conducteurs menant à l'enroulement primaire (32) dudit couplage de transformateur.

11. Amplificateur selon l'une des revendications précédentes, caractérisé en ce qu'un étage amplificateur en aval desdits premier et second transistors MOS-FET comprend des transistors de puissance MOS.

12. Amplificateur selon l'une des revendications précédentes, caractérisé en ce que les transistors à déplétion sont appariés et directement connectés auxdits transistors de type MOS-FET à enrichissement.

## Ansprüche

1. Verstärker mit:
   einem ersten und zweiten MOSFET-Transistor des Verarmungstyps (14, 16), wobei jeder eine getrennte Eingabeelektrode, eine getrennte Ausgabeelektrode und eine direkt angeschlossene Bezugselektrode aufweist,
   Eingabemitteln (32, 42, 46), die die Eingabeelektroden des ersten und zweiten Transistors verbinden, um erste Eingangssignale für den ersten Transistor und zweite Eingangssignale von entgegengesetzter Phase für den zweiten Transistor aus den Eingabemitteln zum Transistor abzuleiten,
   Ausgabemitteln (22), die zwischen den Ausgabeelektroden des ersten und zweiten Transistors geschaltet sind, um die ersten verstärkten Signale des ersten Transistors mit den zweiten verstärkten Signalen von dem zweiten Transistor zu kombinieren und Ausgabesignale für eine Gegentaktstufe zu erzeugen, **dadurch gekennzeichnet,** daß ein freies Schwingen der Polarität zwischen der Bezugselektrode und der Eingabeelektrode des entsprechenden Transistors durch das Fehlen von Vorspannungswiderständen zugelassen wird.

2. Verstärker nach Anspruch 1, wobei steuerbare Widerstandsmittel (34, 48) an die direkt verbundenen Bezugselektroden angeschlossen sind, um die Versorgungsspannung für die Verstärkerstufe zu begrenzen.

3. Verstärker nach Anspruch 2, wobei der Widerstand eine Handeinstellung (48) aufweist.

4. Verstärker nach Anspruch 2, wobei der Widerstand eine transistorisierte Steuerung aufweist.

5. Verstärker nach den Ansprüchen 2, 3 oder 4, wobei der Widerstand (34) an die direkt verbundenen Bezugselektroden von mehr als einem aufeinanderfolgenden Paar von verstärkenden MOSFET-Transistoren (14, 16; 18, 20) angeschlossen ist.

6. Verstärker nach einem der vorhergehenden Ansprüche, wobei das Eingangsmittel eine Sekundärwicklung eines Koppeltransformators aufweist, die die getrennten Eingabeelektroden des ersten und zweiten Transistors indirekt verbindet.

7. Verstärker nach Anspruch 6, wobei der Kondensator zwischen den Eingabeelektroden des ersten und zweiten Transistors angeschlossen ist, um zusammen mit dem Eigabemittel (32) abzuleiten.

8. Verstärker nach einem der Ansprüche 1 bis 5, wobei das Eingabemittel zwei getrennte Kondensatoren (126, 128) aufweist, die jeweils an eine der getrennten Eingabeelektroden des ersten und zweiten Transistors angeschlossen sind.

9. Verstärker nach einem der Ansprüche 1 bis 5, wobei das Eingangsmittel ein Mikrophon (42) aufweist, das direkt an die getrennten Eingabeelektroden des ersten und zweiten Transistors angeschlossen ist.

10. Verstärker nach Anspruch 6, wobei ein MOSFET-Transistor des Anreicherungstyps (36) zwischen den Anschlüssen der Primärwicklung (32) des Koppeltransformators angeordnet ist.

11. Verstärker nach einem der vorhergehenden Ansprüche, wobei eine Verstärkerstufe nach dem ersten und zweiten MOSFET-Transistor einen MOS Leistungstransistor aufweist.

12. Verstärker nach einem der vorhergehenden Ansprüche, wobei Transistoren des Verarmungstyps angepaßt und direkt angeschlossen sind an die MOSFET-Transistoren des Anreicherungstyps.

FIG.1

FIG. 2 A

42

14

16

48

10

22

+

44

FIG. 2B

42

14

16

48

10

+

120

118

122

FIG. 3
A

46

14

16

48

10

22

+

44

FIG. 3
B

126

128

14

16

48

10

+

120

118

122

## FIG. 4A

## FIG. 4B

10